# EUROPEAN PATENT APPLICATION

(11) **EP 4 043 205 A1**
(43) Date of publication of application: **17.08.2022**
(21) Application number: 20875261.8
(22) Date of filing: 17.09.2020
(51) Int. Cl.: B32B 15/085, C09D 5/00, C09D 123/00, C09D 123/12, C09D 123/28, C09D 151/06, C23C 28/00, H05K 1/03, H05K 3/18

(54) **LAYERED BODY, SHAPED ARTICLE, PRINTED-WIRING BOARD AND ELECTROMAGNETIC WAVE SHIELD**

(30) Priority: 10.10.2019 JP 2019186813
(71) Applicant: DIC Corporation, Tokyo 174-8520 (JP)
(72) Inventor: FUJIKAWA, Wataru, Takaishi-shi, Osaka 592-0001 (JP); IWAMOTO, Akihiro, Takaishi-shi, Osaka 592-0001 (JP); SHIRAKAMI, Jun, Takaishi-shi, Osaka 592-0001 (JP)
(74) Representative: Beckmann, Claus
(86) International application number: PCT/JP2020/035181
(87) International publication number: WO 2021/070591

(57) **Abstract**

A laminate that includes a substrate made of a polyolefin-based resin and is excellent in adhesion between the substrate and a metal plating layer is provided in a simple manner without roughening the surface of the substrate. In addition, a molded article, a printed wiring board, and an electromagnetic wave shield using the laminate using the same are provided. Used is a laminate configured such that on a substrate (A) made of a polyolefin-based resin (a), a primer layer (B) containing a polyolefin-based resin (b) that is organic solvent soluble or water dispersible, a metal particle layer (C), and a metal plating layer (D) are sequentially laminated.

## Description

### TECHNICAL FIELD

The present invention relates to a laminate using a substrate made of a polyolefin-based resin, a molded article, a printed wiring board, and an electromagnetic wave shield.

### BACKGROUND ART

Techniques for forming a metal plating film on the surface of an insulating substrate made of a resin or the like are conventionally well known, and circuit components, electromagnetic wave shielding members, and decorative materials such as automotive decorative parts, in which a metal layer made of copper or the like is formed, are known. In addition, as methods for forming a metal layer (metal coating film) on the surface of an insulating substrate, methods using an electrolytic plating method or an electroless plating method are known.

Here, in the case where a metal plating layer is formed on the surface of an insulating substrate, as the insulating substrate, a relatively highly polar resin such as a polycarbonate resin, an ABS resin, polyamide, polystyrene, polyphenylene sulfide, or a polyester resin such as a polyalkylene terephthalate has been used to ensure adhesion between the insulating substrate and the metal layer. However, in the case where a non-polar substrate such as a polyolefin resin is used as an insulating substrate, and a metal plating layer is formed thereon, it has been difficult to obtain sufficient adhesion.

As a method for forming a metal plating layer on a polyolefin-based resin substrate, a roughening method in which the surface of a polyolefin-based resin substrate is roughened with a powerful oxidizing agent to impart an anchoring effect has been known (see, e.g., NTL 1). In addition, a method in which an electrically conductive paste obtained by mixing a metal component that serves as an electroless plating catalyst or an electrically conductive polymer with a resin component is applied to the surface of a polyolefin-based resin substrate, thereby forming a plating base layer having adhesion imparted thereto, has been considered (see, e.g., PTLs 2 and 3). Further, a method in which as a pretreatment for plating, the surface of a polyolefin-based resin substrate is swollen with an organic solvent and modified by UV irradiation, and then the surface of the polyolefin-based resin substrate is subjected to electroless nickel plating, has also been proposed (see, e.g., PTL 4).

However, in the roughening method, because a powerful oxidizing agent such as hexavalent chromium has to be used, there have been concerns about the environmental impacts. In addition, in the method where an electrically conductive paste is used as a plating base, because a resin component that improves adhesion and a metal component that reduces adhesion coexist in the paste, adhesion is traded off for plating deposition properties; as a result, there has been a problem in that the adhesion between the polyolefin-based resin substrate and the metal plating film is insufficient. Further, in the formation of a metal plating film by devising the pretreatment for plating, with changes in the manufacturer or lot number of the polyolefin-based resin substrate, the kinds and proportions of the resin component and the inorganic filler change; as a result, there has also been a problem in that the plating pretreatment conditions have to be optimized for every substrate, which takes time and effort.

### CITATION LIST

### PATENT LITERATURE

PTL 1: JP-A-2015-67624
PTL 2: WO 2014/132794
PTL 3: JP-A-2016-160506

### NON PATENT LITERATURE

NTL 1: Practical Surface Technology Vol. 27 (1980), No. 11, pp. 561 to 565

### SUMMARY OF INVENTION

### TECHNICAL PROBLEM

The invention addresses the problem of providing a laminate that includes a substrate made of a polyolefin-based resin and is excellent in adhesion between the substrate and a metal plating layer in a simple manner without roughening the surface of the substrate, as well as a molded article, a printed wiring board, and an electromagnetic wave shield using the same.

### SOLUTION TO PROBLEM

The present inventors have conducted extensive research to solve the above problems. As a result, they have found that when a primer layer containing a polyolefin-based resin that is organic solvent soluble or water dispersible is provided on a substrate made of a polyolefin-based resin, and a metal particle layer and a metal plating layer are sequentially laminated thereon, such a laminate can solve the above problems, and thus accomplished the invention.

That is, the invention provides a laminate configured such that on a substrate (A) made of a polyolefin-based resin (a), a primer layer (B) containing a polyolefin-based resin (b) that is organic solvent soluble or water dispersible, a metal particle layer (C), and a metal plating layer (D) are sequentially laminated. The invention also provides a printed wiring board and an electromagnetic wave shield using the same.

### ADVANTAGEOUS EFFECTS OF INVENTION

The laminate of the invention is characterized in that the adhesion of the metal plating layer to the substrate made of a polyolefin-based resin is extremely excellent as compared to conventional methods, including a method in which the substrate is roughened, a method in which an electrically conductive paste is used as a plating base, and a method in which the substrate is pretreated. Therefore, the laminate of the invention is suitably applicable, for example, to electrically conductive films for touch panels, metal meshes for touch panels, electronic circuits, organic solar cells, electronic terminals, organic EL elements, organic transistors, rigid printed wiring boards, flexible printed wiring boards, electromagnetic wave shields, RFID for non-contact IC cards and the like, and wiring members for electromagnetic wave shields and the like. In addition, the laminate can be used for decorative plating applications for molded articles. In particular, the laminate is most suitable for electromagnetic wave shielding applications for automobiles and the like, where simultaneous achievement of weight reduction and electromagnetic wave shielding properties is required.

### DESCRIPTION OF EMBODIMENTS

The laminate of the invention is configured such that on a substrate (A) made of a polyolefin-based resin (a), a primer layer (B) containing a polyolefin-based resin (b) that is organic solvent soluble or water dispersible, a metal particle layer (C), and a metal plating layer (D) are sequentially laminated.

The laminate of the invention may be a laminate in which the primer layer (B) and the like are sequentially laminated on one side of the substrate (A) made of a polyolefin-based resin, or may also be a laminate in which the primer layer (B) and the like are sequentially laminated on both sides of the substrate (A).

As the polyolefin-based resin (a), for example, polyethylene, polypropylene, ethylene-propylene copolymers, ethylene-propylene-diene copolymers, polybutylene, polybutadiene, polyvinyl chloride, chlorinated polypropylene, and the like can be mentioned. In addition, the polyolefin-based resin (a) preferably contains an elastomer. As the elastomer, for example, ethylene-butene copolymers, ethylene-octene copolymers, and the like can be mentioned.

The shape of the substrate (A) is not particularly limited, and the thickness thereof is preferably about 0.5 to 100 mm, and more preferably about 0.5 to 10 mm. Further, as the laminate of the invention, one that is relatively flexible is preferable, and one that is about 1 to 200 µm is preferable.

In the case where the shape of the substrate (A) is film-like or sheet-like, usually, the thickness of the film-like or sheet-like substrate is preferably within a range of 1 to 5,000 µm, more preferably within a range of 1 to 300 µm, and still more preferably within a range of 1 to 200 µm.

In addition, because the adhesion between the substrate (A) and the below-described primer layer (B) can be improved, the surface of the substrate (A) may have been subjected to a surface treatment for the purpose of forming fine irregularities, cleaning contaminants adhering to the surface, or introducing functional groups such as a hydroxyl group, a carbonyl group, and a carboxyl group, for example. Specifically, the surface may have been subjected to a plasma discharge treatment such as a corona discharge treatment, a dry treatment such as a UV treatment, or a wet treatment using water, an aqueous solution of acid/alkali or the like, an organic solvent, or the like, for example.

The primer layer (B) can be formed by applying a primer resin composition to part or all of the surface of the substrate (A), and removing the solvent contained in the primer resin composition, such as an organic solvent or an aqueous medium.

As a method for applying the primer resin composition to the surface of the substrate (A), for example, methods such as a gravure method, a coating method, a screen method, a roller method, a rotary method, and a spray method can be mentioned.

For the purpose of further improving the adhesion to the metal layer (C), the surface of the primer layer (B) has preferably been surface-treated, for example, by a plasma discharge treatment method such as a corona discharge treatment method, a dry treatment method such as a UV treatment method, or a wet treatment method using water, an acidic or alkaline chemical liquid, an organic solvent, or the like.

As a method for applying the primer resin composition to the surface of the substrate (A) and then removing the solvent contained in the resulting coating layer, for example, a method in which drying is performed using a dryer to volatilize the solvent is common. The drying temperature may be set to a temperature within a range where the solvent can be volatilized, and an adverse effect, such as thermal deformation, is not given to the substrate (A).

The film thickness of the primer layer (B) formed using the primer resin composition is, although this varies depending on the intended use of the laminate of the invention, because the adhesion between the substrate (A) and the metal layer (C) can be further improved, preferably within a range of 10 nm to 30 µm, more preferably within a range of 10 nm to 1 µm, and still more preferably within a range of 10 nm to 500 nm.

As the primer resin composition, one containing a polyolefin-based resin (b) that is organic solvent soluble or water dispersible is used.

As the polyolefin-based resin (b), polypropylene, chlorinated polypropylene, chlorinated polypropylene-modified acrylic resins, aqueous chlorinated polypropylene, and the like can be mentioned. Among them, because the adhesion to the substrate (A) is improved, chlorinated polypropylene and chlorinated polypropylene-modified acrylic resins are preferable. In addition, these polyolefin-based resins (b) can be used alone, and it is also possible to use two or more kinds together.

In addition, as the polyolefin-based resin (b), a resin having a carboxyl group is preferable. The carboxyl group in the resin may be present in any of the polymer backbone, ends, and sidechains. As methods for introducing a carboxyl group, a method in which an unsaturated monomer having a carboxyl group such as (meth)acrylic acid, maleic acid, or maleic anhydride is copolymerized during polyolefin polymerization, a method in which an unsaturated monomer having a carboxyl group such as (meth)acrylic acid, maleic acid, or maleic anhydride is graft-polymerized to the polyolefin resin, and the like can be mentioned. Incidentally, in the invention, "(meth)acrylic" refers to either or both of "acrylic" and "methacrylic".

The carboxyl group content in the polyolefin-based resin (b) is, because the adhesion between layers can be improved, preferably within a range of 0.1 to 5 mass%, and more preferably within a range of 1 to 5 mass%.

The melting point of the polyolefin-based resin (b) is, because the adhesion between layers can be improved, preferably within a range of 65 to 120°C, and more preferably within a range of 75 to 85°C.

In the case where chlorinated polypropylene is used as the polyolefin-based resin (b), because the adhesion between layers can be improved, the degree of chlorination is preferably within a range of 15 to 30 mass%, more preferably within a range of 15 to 26 mass%, and still more preferably within a range of 21 to 26 mass%.

The chlorinated polypropylene-modified acrylic resin is obtained by polymerizing a (meth)acrylic monomer in chlorinated polypropylene dissolved in an organic solvent, thereby grafting an acrylic resin to the chlorinated polypropylene. Because the adhesion between layers can be improved by compositionally adjusting the (meth)acrylic monomer, it is preferable to use a chlorinated polypropylene-modified acrylic resin.

In the case where a resin having a carboxyl group is used as the polyolefin-based resin (b), when a cross-linking agent is used together, the adhesion between layers can be improved. As the cross-linking agent, a cross-linking agent having a functional group that reacts with the carboxyl group that the polyolefin-based resin (b) has is preferable. As such cross-linking agents, for example, cross-linking agents having an epoxy group, an amino group, a carbodiimide group, an oxazoline group, an isocyanate group, a blocked isocyanate group, a polyvalent metal, and the like can be mentioned. Among these cross-linking agents, it is preferable to use a cross-linking agent having an epoxy group. In addition, these cross-linking agents can be used alone, and it is also possible to use two or more kinds together.

Because the adhesion between layers can be improved, the amount of cross-linking agent used is, per 100 parts by mass of the polyolefin-based resin (b), preferably within a range of 0.1 to 100 parts by mass, and more preferably within a range of 1 to 10 parts by mass.

In addition, the polyolefin-based resin (b) can also be used together with other resins. As other resins, for example, urethane resins, vinyl resins, urethane-vinyl composite resins, epoxy resins, imide resins, amide resins, melamine resins, phenol resins, urea formaldehyde resins, blocked isocyanates using phenol or the like as a blocking agent, polyvinyl alcohol, polyvinylpyrrolidone, and the like can be mentioned.

As the primer resin composition, because the coating properties are improved, resins including the polyolefin-based resin (b) are preferably contained within a range of 0.1 to 70 mass%, more preferably contained within a range of 1 to 20 mass%, in the primer resin composition.

As the primer resin composition, one obtained by dissolving or dispersing the polyolefin-based resin (b) and other resins in an organic solvent or an aqueous medium can be used.

As the organic solvent, for example, toluene, ethyl acetate, butyl acetate, methyl ethyl ketone, methyl isobutyl ketone, cyclohexanone, methylcyclohexane, methanol, ethanol, and the like can be mentioned. In addition, as the aqueous medium, water, an organic solvent miscible with water, and a mixture thereof can be mentioned.

As the organic solvent miscible with water, for example, alcohol solvents such as methanol, ethanol, n-propanol, isopropanol, ethyl carbitol, ethyl cellosolve, and butyl cellosolve; ketone solvents such as acetone and methyl ethyl ketone; alkylene glycol solvents such as ethylene glycol, diethylene glycol, and propylene glycol; polyalkylene glycol solvents such as polyethylene glycol, polypropylene glycol, and polytetramethylene glycol; lactam solvents such as N-methyl-2-pyrrolidone, and the like can be mentioned.

In addition, the polyolefin-based resin (b) and other resins may have, if necessary, for example, cross-linkable functional groups such as an alkoxysilyl group, a silanol group, a hydroxyl group, and an amino group. With respect to a cross-linked structure formed by such a cross-linkable functional group, the cross-linked structure may have already been formed before the application of the primer resin composition. In addition, it is also possible that after the fluid is applied, the cross-linked structure is formed by heating in a calcination step or the like, for example.

If necessary, known additives such as pH adjusters, film-forming aids, leveling agents, thickeners, water repellents, and antifoaming agents may be suitably added to the primer resin composition.

The metal particle layer (C) is formed on the primer layer (B). As metals for constituting the metal particle layer (C), transition metals and compounds thereof can be mentioned. Among them, ionic transition metals are preferable. As such ionic transition metals, copper, silver, gold, nickel, palladium, platinum, cobalt, and the like can be mentioned. Among these ionic transition metals, copper, silver, and gold are preferable because they have low electrical resistance and provide a corrosion-resistant electrically conductive pattern. In addition, the metal particle layer (C) is preferably porous, and in this case, voids are present in the layer.

In addition, as metals for constituting the metal plating layer (D), copper, nickel, chromium, cobalt, tin, and the like can be mentioned. Among them, copper is preferable because it has low electrical resistance and provides a corrosion-resistant electrically conductive pattern.

In the laminate of the invention, it is preferable that voids present in the metal particle layer (C) are filled with the metal that constitutes the metal plating layer (D), and, because the adhesion between the metal particle layer (C) and the metal plating layer (D) is further improved, it is preferable that even the voids in the metal particle layer (C) present near the interface between the substrate (A) and the metal particle layer (C) are filled with the metal that constitutes the metal plating layer (D).

As a method for producing the laminate of the invention, a method in which the primer layer (B) is first formed on the substrate (A), then a fluid containing metal particles (c) is applied, the organic solvent and the like contained in the fluid are removed by drying to form a metal layer (C), followed by electroless plating, and subsequently electrolytic plating is performed to form the metal plating layer (D), can be mentioned. During the formation of the metal particle layer (C), because the adhesion to the metal plating layer (D) is improved, it is preferable that the fluid containing metal particles (c) is applied onto the primer layer (B) and dried to form a metal particle layer (C'), followed by calcination to remove organic compounds including a dispersant present in the metal particle layer (C') and form voids, thereby forming a porous metal particle layer (C).

The shape of the metal particles (c) used to form the metal particle layer (C) is preferably particulate or fibrous. In addition, the metal particles (c) are preferably nano-sized. Specifically, in the case where the shape of the metal particles (c) is particulate, the average particle size is, because a fine mesh-like electrically conductive pattern can be formed, and the resistance value can be further reduced, preferably within a range of 1 to 100 nm, and more preferably within a range of 1 to 50 nm. Incidentally, the "average particle size" is a volume mean measured by a dynamic light scattering method from the metal particles (c) diluted with a good dispersion solvent. For this measurement, "Nanotrack UPA-150" manufactured by Microtrack can be used.

Meanwhile, in the case where the shape of the metal particles (c) is fibrous, the fiber diameter is, because a fine electrically conductive pattern can be formed, and the resistance value can be further reduced, preferably within a range of 5 to 100 nm, and more preferably within a range of 5 to 50 nm. In addition, the fiber length is preferably within a range of 0.1 to 100 µm, and more preferably within a range of 0.1 to 30 µm.

The content of the metal particles (c) in the fluid is preferably within a range of 1 to 90 mass%, more preferably within a range of 1 to 60 mass%, and still more preferably within a range of 1 to 10 mass%.

As components that may be blended in the fluid, dispersants and solvents for dispersing the metal particles (c) in the solvent can be mentioned, and also, if necessary, the below-described surfactants, leveling agents, viscosity modifiers, film-forming aids, antifoaming agents, preservatives, and the like can be mentioned.

In order to disperse the metal particles (c) in a solvent, it is preferable to use a dispersant. As the dispersant, for example, dodecanethiol, 1-octanethiol, triphenyl phosphine, dodecylamine, polyethylene glycol, polyvinylpyrrolidone, polyethyleneimine, polyvinylpyrrolidone; fatty acids such as myristic acid, octanoic acid, and stearic acid; carboxyl group-containing polycyclic hydrocarbon compounds such as cholic acid, glycyrrhizic acid, and abietic acid, and the like can be mentioned. Among them, polymeric dispersants are preferable because, as a result of making the metal particle layer (C) porous, the adhesion between the metal particle layer (C) and the below-described metal plating layer (D) can be improved. As such polymeric dispersants, polyalkyleneimines such as polyethyleneimine and polypropyleneimine, a compound in which a polyoxyalkylene is added to such a polyalkyleneimine, a urethane resin, an acrylic resin, a compound in which a phosphoric acid group is contained in the urethane resin or the acrylic resin, and the like can be mentioned.

When a polymeric dispersant is used as the dispersant as described above, as compared to a small-molecule dispersant, the dispersant in the metal particle layer (C) can be removed to make the layer porous, and the resulting void size can be increased, making it possible to form nano- to submicron-sized voids. Such voids can be easily filled with the metal that constitutes the below-described metal plating layer (D), and the filling metal serves as an anchor, whereby the adhesion between the metal particle layer (C) and the below-described metal plating layer (D) can be significantly improved.

The amount of dispersant used to disperse the metal particles (c) is, per 100 parts by mass of the metal particles (c), preferably within a range of 0.01 to 50 parts by mass, and more preferably within a range of 0.01 to 10 parts by mass.

In addition, in the case where the dispersant is removed by calcination to form the metal layer (C) as a porous layer for the purpose of further improving the adhesion between the metal particle layer (C) and the below-described metal plating layer (D), the amount is, per 100 parts by mass of the metal particles (c), preferably within a range of 0.1 to 10 parts by mass, and more preferably within a range of 0.1 to 5 parts by mass.

As a solvent used for the fluid, an aqueous medium or an organic solvent can be used. As the aqueous medium, for example, distilled water, ion exchanged water, pure water, ultrapure water, and the like can be mentioned. In addition, as the organic solvent, alcohol compounds, ether compounds, ester compounds, ketone compounds, and the like can be mentioned.

As the alcohol, for example, methanol, ethanol, n-propanol, isopropyl alcohol, n-butanol, isobutyl alcohol, sec-butanol, tert-butanol, heptanol, hexanol, octanol, nonanol, decanol, undecanol, dodecanol, tridecanol, tetradecanol, pentadecanol, stearyl alcohol, allyl alcohol, cyclohexanol, terpineol, terpineol, dihydroterpineol, ethylene glycol monomethyl ether, ethylene glycol monoethyl ether, ethylene glycol monobutyl ether, diethylene glycol monoethyl ether, diethylene glycol monomethyl ether, diethylene glycol monobutyl ether, tetraethylene glycol monobutyl ether, propylene glycol monomethyl ether, dipropylene glycol monomethyl ether, tripropylene glycol monomethyl ether, propylene glycol monopropyl ether, dipropylene glycol monopropyl ether, propylene glycol monobutyl ether, dipropylene glycol monobutyl ether, tripropylene glycol monobutyl ether, and the like can be mentioned.

In addition, in the fluid, in addition to the metal particles (c) and solvents described above, if necessary, ethylene glycol, diethylene glycol, 1,3-butanediol, isoprene glycol, and the like can be used.

As the surfactant, a general surfactant can be used. For example, di-2-ethylhexyl sulfosuccinate, dodecylbenzene sulfonate, alkyl diphenyl ether disulfonates, alkyl naphthalene sulfonates, hexametaphosphate, and the like can be mentioned.

As the leveling agent, a general leveling agent can be used. For example, silicone-based compounds, acetylenediol-based compounds, fluorine-based compounds, and the like can be mentioned.

As the viscosity modifier, a general thickener can be used. For example, acrylic polymers and synthetic rubber latexes that can increase the viscosity through adjustment to alkaline, urethane resins that can increase the viscosity through the association of molecules, hydroxyethyl cellulose, carboxymethyl cellulose, methyl cellulose, polyvinyl alcohol, watered castor oil, amide wax, polyethylene oxide, metal soap, dibenzylidene sorbitol, and the like can be mentioned.

As the film-forming aid, a general film-forming aid can be used. For example, anionic surfactants (dioctyl sulfosuccinate sodium salt, etc.), hydrophobic nonionic surfactants (sorbitan monooleate, etc.), polyether-modified siloxane, silicone oil, and the like can be mentioned.

As the antifoaming agent, a general antifoaming agent can be used. For example, silicone-based antifoaming agents, nonionic-based surfactants, polyethers, higher alcohols, polymer-based surfactants, and the like can be mentioned.

As the preservative, a general preservative can be used. For example, isothiazoline-based preservatives, triazine-based preservatives, imidazole-based preservatives, pyridine-based preservatives, azole-based preservatives, pyrithione-based preservatives, and the like can be mentioned.

The viscosity of the fluid (value measured at 25°C using a Brookfield viscometer) is preferably within a range of 0.1 to 500,000 mPa·s, and more preferably within a range of 0.5 to 10,000 mPa·s. In addition, in the case where the fluid is applied (printed) by the below-described inkjet printing method, letterpress reverse printing, or a like method, its viscosity is preferably within a range of 5 to 20 mPa·s.

As methods for applying or printing the fluid onto the primer layer (B), for example, an inkjet printing method, a reverse printing method, a screen printing method, an offset printing method, a gravure printing method, a flexo printing method, a pad printing method, a spin coating method, a spray coating method, a bar coating method, a die coating method, a slit coating method, a roll coating method, a dip coating method, a rotary coating method, a capillary coating method, and the like can be mentioned.

The mass per unit area of the metal particle layer (C) is preferably within a range of 1 to 30,000 mg/m², and preferably within a range of 1 to 5,000 mg/m². The thickness of the metal particle layer (C) can be adjusted by controlling the treatment time, the current density, the amount of plating additive used, and the like in a plating treatment step in the formation of the metal plating layer (D).

The metal plating layer (D) is a layer formed on the metal particle layer (C), and as a method for forming the same, a method in which the formation is done by a plating treatment is preferable. As the plating treatment, for example, wet plating methods such as an electrolytic plating method and an electroless plating method, dry plating methods such as a sputtering method and a vacuum vapor deposition method, and the like can be mentioned. In addition, the metal plating layer (D) may also be formed by a combination of two or more of these plating methods.

The electroless plating method is a method in which, for example, the metal that constitutes the metal layer (C) is brought into contact with an electroless plating solution to deposit a metal such as copper contained in the electroless plating solution, thereby forming an electroless plating layer (coating film) formed of a metal coating film.

As the electroless plating solution, for example, one containing a metal such as copper, nickel, chromium, cobalt, or tin, a reducing agent, and a solvent such as an aqueous medium or an organic solvent can be mentioned.

As the reducing agent, for example, dimethylaminoborane, hypophosphite, sodium hypophosphite, dimethylamineborane, hydrazine, formaldehyde, sodium borohydride, phenol, and the like can be mentioned.

In addition, the electroless plating solution used may contain a complexing agent if necessary, examples of complexing agents including monocarboxylic acids such as acetic acid and formic acid; dicarboxylic acid compounds such as malonic acid, succinic acid, adipic acid, maleic acid, and fumaric acid; hydroxycarboxylic acid compounds such as malic acid, lactic acid, glycolic acid, gluconic acid, and citric acid; amino acid compounds such as glycine, alanine, iminodiacetic acid, arginine, aspartic acid, and glutamic acid; aminopolycarboxylic acid compounds such as iminodiacetic acid, nitrilotriacetic acid, ethylenediaminediacetic acid, ethylenediaminetetraacetic acid, and diethylenetriaminepentaacetic acid; and like organic acids, as well as soluble salts of these organic acids (sodium salt, potassium salt, ammonium salt, etc.), and amine compounds such as ethylenediamine, diethylenetriamine, and triethylenetetramine.

The electrolytic plating method is a method in which, for example, the metal that constitutes the metal layer (C) or the electroless plating layer (coating film) formed by the electroless treatment is energized with the surface thereof being in contact with an electrolytic plating solution, whereby a metal such as copper contained in the electrolytic plating solution is deposited on the surface of the metal particles (c) constituting the metal layer (C) or the electroless plating layer (coating film) formed by the electroless treatment provided on the cathode, thereby forming an electrolytic plating layer (metal coating film).

As the electrolytic plating solution, for example, one containing a sulfide of a metal such as copper, nickel, chromium, cobalt, or tin, sulfuric acid, and an aqueous medium can be mentioned. Specifically, one containing copper sulfate, sulfuric acid, and an aqueous medium can be mentioned.

The electroless plating solution and the electrolytic plating solution are preferably used within a range of 20 to 98°C.

With respect to the substrate (A) made of a polyolefin-based resin (a), because the heat resistance of the substrate itself is low, it may be difficult to give a high-temperature thermal history sufficient to impart electrical conductivity to the metal particle layer (C). In that case, as a method for forming a metal plating layer (D) on the metal particle layer (C), it is preferable to perform electroless plating and then electrolytic plating.

In addition, as the dry plating treatment step, a sputtering method, a vacuum vapor deposition method, or the like can be used. The sputtering method is a method in which an inert gas (mainly argon) is introduced in a vacuum, negative ions are applied to a material for forming a metal plating layer (D) to generate a glow discharge, the inert gas atoms are next ionized, and the gas ions are violently struck against the surface of the material for forming a metal plating layer (D) at high speed so that the atoms and molecules constituting the material for forming a metal plating layer (D) are sputtered and vigorously attached to the surface of the metal layer (C), thereby forming the metal plating layer (D).

As materials for forming the metal plating layer (D) for use in the sputtering method, for example, chromium, copper, titanium, silver, platinum, gold, nickel-chromium alloys, stainless steel, copper-zinc alloys, indium tin oxide (ITO), silicon dioxide, titanium dioxide, niobium oxide, zinc oxide, and the like can be mentioned.

When a plating treatment is performed by the sputtering method, for example, a magnetron sputtering apparatus or the like can be used.

The thickness of the metal plating layer (D) is preferably within a range of 0.1 to 50 µm. The thickness of the metal plating layer (D) can be adjusted by controlling the treatment time, the current density, the amount of plating additive used, and the like in a plating treatment step in the formation of the metal plating layer (D).

The laminate of the invention obtained by the above method can be used as a printed wiring board. When the laminate of the invention is used as a printed wiring board, a fluid containing the metal particles (c) is applied to form the metal layer (C) in a position corresponding to a desired pattern shape to be formed, whereby a printed wiring board having a desired pattern can be produced.

In addition, the printed wiring board can be produced, for example, by a photolithography-etching method, such as a subtractive method or a semi-additive method, or a method in which plating is performed on the printed pattern of the metal particle layer (C).

The subtractive method is a method in which an etching resist layer having a shape corresponding to a desired pattern shape is formed on the metal plating layer (D) constituting the laminate of the invention previously produced, and, by the subsequent developing treatment, portions of the metal particle layer (C), the metal plating layer (D), and the like from which the resist has been removed are dissolved with a chemical liquid and removed, thereby forming a desired pattern. As the chemical liquid, a chemical liquid containing copper chloride, iron chloride, or the like can be used.

The semi-additive method is a method in which the primer layer (B) and the metal particle layer (C) are formed on both or one side of the substrate (A) made of a polyolefin-based resin, a plating resist layer having a shape corresponding to a desired pattern is formed on the surface of the metal particle layer (C), a metal plating layer (D) is next formed by an electroless plating method, an electrolytic plating method, or a combination thereof, and subsequently the plating resist layer and the metal layer (C) in contact therewith are dissolved in a chemical liquid or the like and removed, thereby forming a desired pattern. In addition, although the metal particle layer (C) is formed as a plating base layer, instead of the plating base layer formed only of the metal particle layer (C), a metal layer formed on the metal particle layer (C) by an electroless plating method, an electrolytic plating method, or a combination thereof may also be used as a plating base layer.

In addition, the method in which plating is performed on the printed pattern of the metal layer (C) is a method in which on the primer layer (B) formed on both or one side of the substrate (A), a pattern of the metal layer (C) is printed by an inkjet method, a reverse printing method, or the like, and the metal plating layer (D) is formed on the surface of the metal layer (C) by an electroless plating method, an electrolytic plating method, or a combination thereof, thereby forming a desired pattern.

The laminate of the invention obtained by the above method is characterized in that the adhesion of the metal plating layer to the substrate made of a polyolefin-based resin is extremely excellent as compared to conventional methods, including a method in which the substrate is roughened, a method in which an electrically conductive paste is used as a plating base, and a method in which the substrate is pretreated. Therefore, the laminate of the invention is suitably applicable, for example, to electrically conductive films for touch panels, metal meshes for touch panels, electronic circuits, organic solar cells, electronic terminals, organic EL elements, organic transistors, rigid printed wiring boards, flexible printed wiring boards, electromagnetic wave shields, RFID for non-contact IC cards and the like, and wiring members for electromagnetic wave shields and the like. In addition, the laminate can be used for decorative plating applications for molded articles. In particular, the laminate is most suitable for electromagnetic wave shielding applications for automobiles and the like, where simultaneous achievement of weight reduction and electromagnetic wave shielding properties is required.

### EXAMPLES

Hereinafter, the invention will be described in detail with reference to examples. Incidentally, the invention is in no way limited to the following examples.

### [Preparation Example 1: Preparation of Primer Resin Composition (1)]

A mixed solvent of methylcyclohexane and methyl ethyl ketone (methylcyclohexane/methyl ethyl ketone = 80/20 (mass ratio)) was added to a polypropylene resin ("AUROREN 500S" manufactured by Nippon Paper Industries, Co., Ltd., melting point: 75°C) and uniformly mixed to give a primer resin composition (1) having a nonvolatile content of 2 mass%.

### [Preparation Example 2: Preparation of Primer Resin Composition (2)]

The same procedure as in Preparation Example 1 was performed except that the polypropylene resin used in Preparation Example 1 was replaced with a polypropylene resin ("AUROREN 150S" manufactured by Nippon Paper Industries, Co., Ltd., melting point 120°C), thereby giving a primer resin composition (2) having a nonvolatile content of 2 mass%.

### [Preparation Example 3: Preparation of Primer Resin Composition (3)]

Toluene was added to a chlorinated polypropylene resin ("SUPERCHLON 422S" manufactured by Nippon Paper Industries, Co., Ltd., maleic acid-modified type, melting point: 75°C) and uniformly mixed, thereby giving a primer resin composition (3) having a nonvolatile content of 2 mass%.

### [Preparation Example 4: Preparation of Primer Resin Composition (4)]

95 parts by mass of a toluene solution of a chlorinated polypropylene resin ("SUPERCHLON 422S" manufactured by Nippon Paper Industries, Co., Ltd., maleic acid-modified type, melting point: 75°C) having a nonvolatile content of 2 mass% and 5 parts by mass of a toluene solution of an epoxy cross-linking agent (DENACOL EX-201 manufactured by Nagase ChemteX Corporation) having a nonvolatile content of 2 mass% were uniformly mixed, thereby giving a primer resin composition (4) having a nonvolatile content of 2 mass%.

### [Preparation Example 5: Preparation of Primer Resin Composition (5)]

The same procedure as in Preparation Example 3 was performed except that the chlorinated polypropylene resin used in Preparation Example 3 was replaced with a chlorinated polypropylene resin ("SUPERCHLON 930S" manufactured by Nippon Paper Industries, Co., Ltd., maleic acid-modified type, melting point: 65°C), thereby giving a primer resin composition (5) having a nonvolatile content of 2 mass%.

### [Preparation Example 6: Preparation of Primer Resin Composition (6)]

The same procedure as in Preparation Example 3 was performed except that the chlorinated polypropylene resin used in Preparation Example 3 was replaced with a chlorinated polypropylene resin ("SUPERCHLON 415S" manufactured by Nippon Paper Industries, Co., Ltd., maleic acid-modified type, melting point: 85°C), thereby giving a primer resin composition (6) having a nonvolatile content of 2 mass%.

### [Preparation Example 7: Preparation of Primer Resin Composition (7)]

The same procedure as in Preparation Example 3 was performed except that the chlorinated polypropylene resin used in Preparation Example 3 was replaced with a chlorinated polypropylene resin ("HARDLEN DX526P" manufactured by Toyobo Co., Ltd., maleic acid-unmodified type, melting point: 81°C), thereby giving a primer resin composition (7) having a nonvolatile content of 2 mass%.

### [Preparation Example 8: Preparation of Primer Resin Composition (8)]

The same procedure as in Preparation Example 3 was performed except that the chlorinated polypropylene resin used in Preparation Example 3 was replaced with a chlorinated polypropylene-modified acrylic resin ("ACRYDIC WML-350" manufactured by DIC Corporation), thereby giving a primer resin composition (8) having a nonvolatile content of 2 mass%.

### [Preparation Example 9: Preparation of Primer Resin Composition (9)]

Ion exchanged water was added to a chlorinated polypropylene resin water dispersion ("SUPERCHLON E-415" manufactured by Nippon Paper Industries, Co., Ltd., maleic acid-modified type) and uniformly mixed, thereby giving a primer resin composition (9) having a nonvolatile content of 2 mass%.

### [Preparation Example 10: Preparation of Fluid (1)]

In accordance with Example 1 of Japanese Patent No. 4573138, cationic silver nanoparticles formed of a flaky mass having a grayish green metallic luster, which is a composite of silver nanoparticles and a cationic group (amino group)-containing organic compound, were obtained. Subsequently, the powder of silver nanoparticles was dispersed in a mixed solvent of 45 parts by mass of ethylene glycol and 55 parts by mass of ion exchanged water to prepare a fluid (1) having 5 mass% of cationic silver nanoparticles.

### [Example 1]

The primer resin composition (1) obtained in Preparation Example 1 was applied to the surface of a polypropylene substrate (manufactured by Engineering Test Service Co., Ltd.; 150 mm × 70 mm × 1 mm thick) using a spin coater to a dry film thickness of 0.1 µm, and then dried at 80°C for 5 minutes using a hot air dryer to form a primer layer on the polypropylene substrate.

Next, the fluid (1) obtained in Preparation Example 10 was applied to the surface of the primer layer formed above using a spin coater to a dry film thickness of 0.1 µm, and then dried at 80°C for 5 minutes using a hot air dryer to form a silver particle layer on the primer.

Next, the polypropylene substrate having formed thereon the primer layer and silver particle layer was immersed in an electroless copper plating solution ("OIC Copper" manufactured by Okuno Chemical Industries Co., Ltd., pH 12.5) at 55°C for 20 minutes to perform electroless copper plating, thereby forming an electroless copper plating layer on the metal particle layer.

Next, setting the electroless copper plating layer formed above on the cathode side and phosphorus-containing copper on the anode side, electrolytic plating was performed using an electrolytic plating solution containing copper sulfate at a current density of 2.5 A/dm² for 30 minutes, thereby further forming an electrolytic copper plating layer on the electroless copper plating layer. The total thickness of the electroless copper plating layer and the electrolytic copper plating layer was 3 µm. Incidentally, as the electrolytic plating solution, 70 g/L of copper sulfate, 200 g/L of sulfuric acid, 50 mg/L of chloride ions, and 5 mL/L of an additive ("TOP LUCINA SF-M" manufactured by Okuno Chemical Industries Co., Ltd.) were used.

By the above method, a laminate (1) having a polyolefin substrate (A), a primer layer (B), a metal layer (C), and a metal plating layer (D) sequentially laminated was obtained.

### [Examples 2 to 9]

The same procedure as in Example 1 was performed except that the primer resin composition (1) used in Example 1 was replaced with the primer resin compositions (2) to (9) obtained in Preparation Examples 2 to 9, thereby giving laminates (2) to (9).

### [Comparative Example 1]

The same procedure as in Example 1 was performed except that no primer layer was formed, thereby giving a laminate (R1) having a substrate (A), a metal layer (C), and a metal plating layer (D) sequentially laminated.

### <Normal Strength; Evaluation by Peel Test>

The peel strength of each laminate obtained above was measured by a method in accordance with IPC-TM-650, NUMBER 2.4.9. The lead width for the measurement was 5 mm, and the peel angle was 90°. Incidentally, although the peel strength tends to exhibit a higher value as the thickness of the plating layer increases, the peel strength measurement in the invention was performed based on the measured value at a plating layer thickness of 15 µm, which is currently widely used.

### <Heat Resistance; Evaluation by Peel Test after Heat Resistance Test (Temperature: 80°C)>

Each laminate obtained above was subjected to a 168-hour acceleration test using a dryer set at 80°C. The peel strength was measured by the same method as the method described above in <Evaluation by Peel Test> except that the laminate after drying was used.

### [Evaluation of Heat Resistance]

Using the peel strength values before and after heating measured above, the retention before and after heating was calculated, and the heat resistance was evaluated according to the following criteria.
A: Retention is 85% or more.
B: Retention is 70% or more and less than 85%.
C: Retention is 55% or more and less than 70%.
D: Retention is less than 55%.

Table 1 shows a summary of the measurement and evaluation results obtained above.

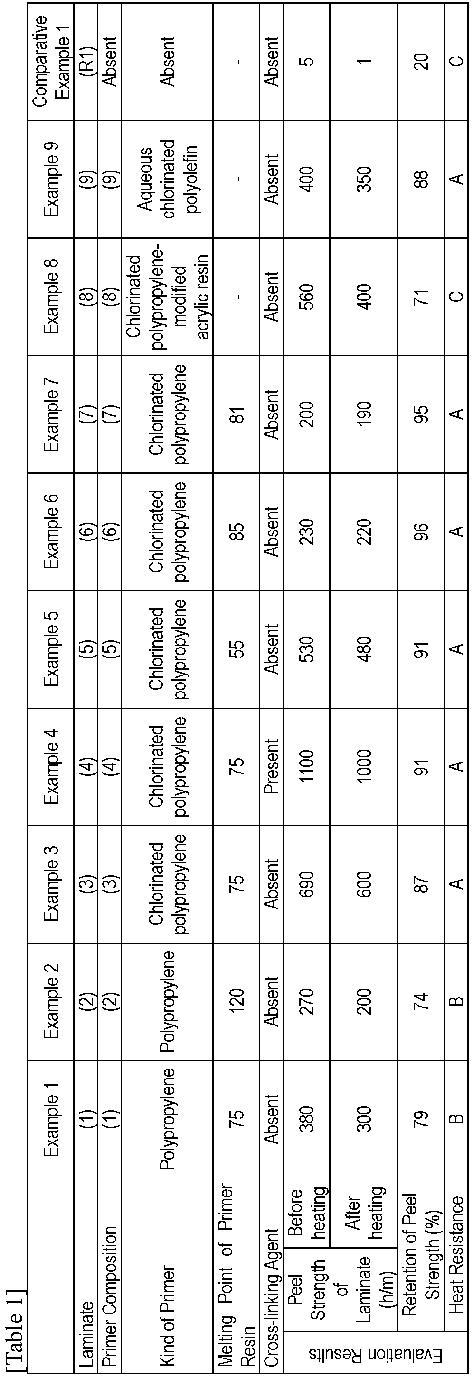

It was observed that the laminates (1) to (9) obtained in Example 1 to 9, which are according to the invention, had practically high peel strength before heating. In addition, it was observed that also after heating at 80°C for 168 hours, the retention of peel strength was high.

Meanwhile, Comparative Example 1 is a laminate having no primer layer (R1), and it was observed that the peel strength before heating was low and not at a practical level. In addition, it was observed that with respect to the peel strength after heating at 80°C for 168 hours, the peel strength further decreased and was not practicable at all.

## Claims

1. A laminate configured such that on a substrate (A) made of a polyolefin-based resin (a), a primer layer (B) containing a polyolefin-based resin (b) that is organic solvent soluble or water dispersible, a metal particle layer (C), and a metal plating layer (D) are sequentially laminated.

2. The laminate according to claim 1, wherein the polyolefin-based resin (b) is at least one member selected from the group consisting of polypropylene, chlorinated polypropylene, a chlorinated polypropylene-modified acrylic resin, and an aqueous chlorinated polypropylene resin.

3. The laminate according to claim 1 or 2, wherein the primer layer (B) is a layer further containing a cross-linking agent.

4. The laminate according to any one of claims 1 to 3, wherein the metal plating layer (D) includes an electroless metal plating layer and an electrolytic metal plating layer sequentially laminated on the metal particle layer (C).

5. A molded article comprising the laminate according to any one of claims 1 to 4.

6. A printed wiring board comprising the laminate according to any one of claims 1 to 4.

7. An electromagnetic wave shield comprising the laminate according to any one of claims 1 to 4.
